# EUROPÄISCHE PATENTSCHRIFT

(11) **EP 0 981 202 B1**
(45) Veröffentlichungstag und Bekanntmachung des Hinweises auf die Patenterteilung: **03.12.2003**
(21) Anmeldenummer: 99114169.8
(22) Anmeldetag: 22.07.1999
(51) Int. Cl.: H03K 17/945, G01S 17/00

(54) **Verfahren zum Sendefrequenzabgleich eines Ultraschall-Nährungsschalters und Ultraschall-Nährungsschalter mit Sendefrequenzabgleich**
Method of adjusting the transmitter frequency of an ultrasonic proximity switch and ultrasonic proximity switch having transmitter frequency adjustment
Procédé de calibrage de la fréquence d'émission d'un détecteur de proximité à ultrasons et détecteur de proximité à ultrasons avec calibrage de la fréquence d'émission

(30) Priorität: 03.08.1998 DE 19834971
(43) Veröffentlichungstag der Anmeldung: 23.02.2000
(73) Patentinhaber: SIEMENS AKTIENGESELLSCHAFT, 80333 München (DE)
(72) Erfinder: Schwarz, Robert, Dipl.-Ing., 92272 Freudenberg (DE)

(56) Entgegenhaltungen:
- EP-A- 0 484 565
- DD-A- 281 259
- US-A- 4 905 208

## Beschreibung

Die Erfindung bezieht sich auf ein Verfahren zum Sendefrequenzabgleich eines Ultraschall-Näherungsschalters nach dem Oberbegriff des Anspruchs 1. Die Druchschrift US-A-4 905 208 beschreibt ein Verfahren zur Abstimmung der Frequenz eines Ultraschallsensors, das dem vorstehend genannten Verfahren entspricht.

Weiterhin betrifft die Erfindung einen Ultraschall-Näherungsschalter nach dem Oberbegriff ples Anspruchs 7.

Verfahren zum Sendefrequenzabgleich eines Ultraschall-Näherungsschalters der obengenannten Art sind bekannt. Dabei handelt es sich um einen fertigungsseitigen, relativ aufwendigen Sendefrequenzabgleichvorgang vor Auslieferung des Ultraschall-Näherungsschalters. Verschiedene Meß- und Einstellanschlüsse müssen kontaktiert werden, um mit Hilfe von Meßgeräten den optimalen Abgleichwert zu finden. Nach Anpassen der Schaltung durch Einlöten eines entsprechenden Bauelements muß die Funktion nochmals überprüft werden. In der Regel können Trimmer zur Frequenzeinstellung wegen Problemen beim Verguß, der Temperaturdrift, dem Preis und der Langzeitzuverlässigkeit nicht eingesetzt werden. Ein Laser oder Sandstrahlabgleich ist teuer und außerdem nicht möglich, weil ein Maximum erst erkannt wird, wenn der optimale Wert bereits überschritten ist.

Daher liegt der Erfindung die Aufgabe zugrunde, ein Verfahren der obengenannten Art anzugeben, das mit geringen Kosten und Hardware-Aufwand einen Sendefrequenzabgleich auch bei einem vergossenen Ultraschall-Näherungsschalter ermöglicht.

Weiterhin besteht die Aufgabe, einen Ultraschall-Näherungsschalter der obengenannten Art zu schaffen, der ohne großen zusätzlichen Kostenaufwand einen automatisierten Sendefrequenzabgleich ermöglicht.

Diese Aufgaben werden durch das Verfahren nach Anspruch 1 und den Ultraschallnäherungssensor nach Anspruchs 7 gelöst.

Vorteilhafterweise erfolgt die Veränderung der Steuerspannung durch Zustandswechsel an Ausgängen des Mikroprozessors, was nach Aktivierung des Abgleichsvorgangs, z.B. über eine Parametrierschnittstelle des Mikroprozessors, mit Hilfe eines im Mikroprozessor abgespeicherten Ablaufprogramms auf einfache Weise realisierbar ist. Die Zustandswechsel können darin bestehen, daß an die Ausgänge ein Spannungspotential +U, ein Massepotential oder ein hochohmiger Zustand vorgegeben wird.

Bewirken die Zustandswechsel an einem dem Oszillator vorgeschalteten Netzwerk-Potentialwechsel, so ist auf einfache Weise durch Veränderung der Potential-Pegelkombination mit Hilfe des Netzwerks die Steuerspannung am Oszillator veränderbar.

Vorteilhafterweise ist das elektrische Signal eine dem Verstärker zugeführte Regelspannung.

Die amplitudenmäßige Auswertung des Signals erfolgt durch Vergleich mit einer Referenzspannung, die durch Zustandswechsel an Ausgängen des Mikroprozessors verändert wird. Die Zustandswechsel bewirken an einem Widerstandsnetzwerk Potentialwechsel und ermöglichen eine Vielzahl von Pegelkombinationen mit entsprechenden Abstufungen der Referenzspannung.

Als besonders vorteilhaft hat es sich erwiesen, wenn der Mikroprozessor selbständig die Einstellwerte für die optimale Sendefrequenz ermittelt, indem er aus den erfaßten Amplituden des elektrischen Signals die Höchste auswählt und abspeichert.

Es ist vorteilhaft, wenn eine Meßeinrichtung vorgesehen ist, die zur Messung der Amplitude eines im Ultraschall-Näherungsschalter nach Empfang eines Ultraschallechosignals weiterverarbeiteten elektrischen Signals dient, das proportional zur Amplitude des Ultraschallechosignals ist.

Eine besonders einfache Ausführung ist gegeben, wenn die Meßeinrichtung einen Komparator aufweist, der zum Vergleich der Amplituden des elektrischen Signals und einer amplitudenmäßig durch den Mikroprozessor veränderbaren Referenzspannung dient.

Eine weitere vorteilhafte Ausführung besteht, wenn zwischen einem Eingang des Komparators und Ausgängen des Mikroprozessors ein Netzwerk geschaltet ist und wenn durch Zustandswechsel an den Ausgängen die Referenzspannung veränderbar ist.

Die Erfindung wird im folgenden anhand einer Zeichnung näher erläutert.

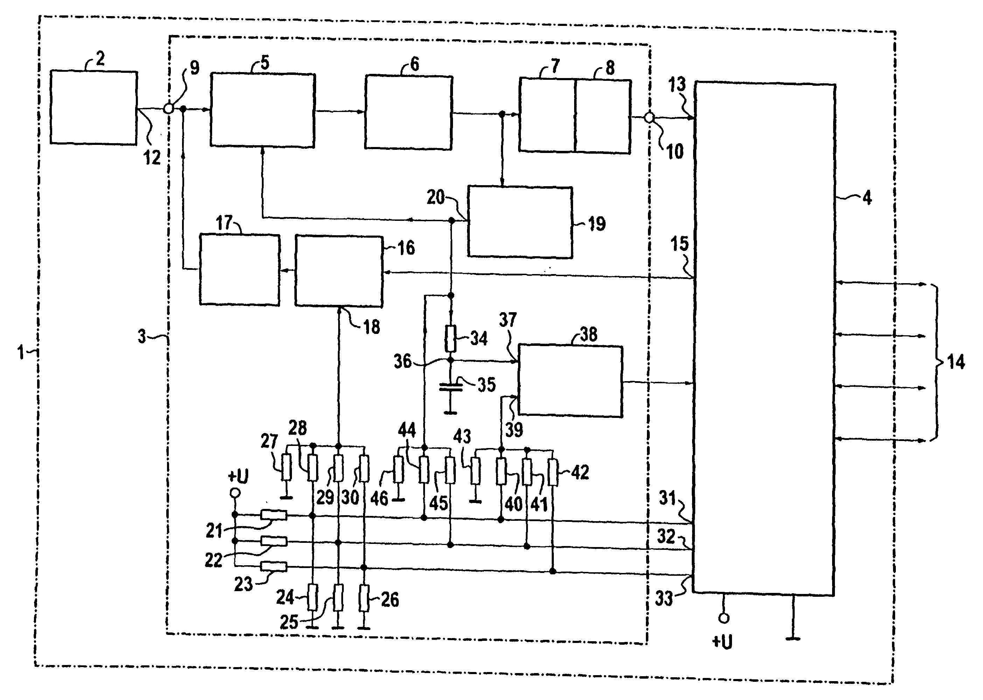

Die Figur zeigt den prinzipiellen schaltungsmäßigen Aufbau eines Ultraschall-Näherungsschalters 1, der im wesentlichen aus einem Ultraschall-Wandler 2, einer Weiterverarbeitungseinheit 3 und einem Mikroprozessor 4 aufgebaut ist. Die Weiterverarbeitungseinheit 3 weist hier einen aus einem Verstärker 5, einem Filter 6, einem Demodulator 7 und einem Komparator 8 aufgebauten Zweig auf, wobei die Komponenten in der genannten Reihenfolge in Serie geschaltet sind und am Eingang 9 der Weiterverarbeitungseinheit 3 der Verstärker 5 und am Ausgang 10 derselben der Komparator 8 liegt. Über eine Regelschleife mit einem Regelverstärker 19 erfolgt eine Rückkopplung zum Verstärker 5. Der Ausgang 12 des Ultraschall-Wandlers 2 ist über den Eingang 9 der Weiterverarbeitungseinheit 3 mit dem Verstärker 5 verbunden. Der Ausgang 10 der Weiterverarbeitungseinheit 3 liegt an einem Eingang 13 des Mikroprozessors 4, der eine Parametrierschnittstelle 14 aufweist. Zwischen einem Ausgang 15 des Mikroprozessors 4 und dem Eingang 9 ist eine Reihenschaltung aus einem Oszillator 16 und einer Sendeendstufe 17 geschaltet.

Im folgenden wird die Wirkungsweise des soweit bekannten Näherungsschalters erläutert.

Der Mikroprozessor 4 aktiviert über seinen Ausgang 15 den Oszillator 16, der abhängig von einer an seinem Eingang 18 anliegenden Steuerspannung ein Anregungssignal mit einer von der Amplitude der Steuerspannung abhängigen Oszillatorfrequenz erzeugt. Dieses Anregungssignal wird nach Verstärkung in der Sendeendstufe 17 an den Wandler 2 weitergeleitet, der ein Ultraschallsignal mit einer der Oszillatorfrequenz entsprechenden Sendefrequenz aussendet. Nach Reflexion der Ultraschallwellen an einem Objekt empfängt der Ultraschall-Wandler 2 ein Ultraschallecho und wandelt dieses in ein elektrisches Signal um. Dieses wird in der Weiterverarbeitungseinheit verstärkt, anschließend gefiltert, demoduliert und vor Übergabe an den Mikroprozessor 4 amplitudenmäßig erfaßt. Das elektrische Signal wird hier nach der Filterung außerdem über einen Regelverstärker 19 in der Weiterverarbeitungseinheit 3 verstärkt und die dann an seinem Ausgang 20 anliegende Regelspannung an den Verstärker 5 rückgeführt. Über die Parametrierschnittstelle 14 des Mikroprozessor 4 wird ermöglicht, Daten in den Mikroprozessor 4 ein- und auszulesen.

Erfindungsgemäß ist der soweit beschriebene Ultraschall-Näherungsschalter 1 mit einem Widerstandsnetzwerk versehen, das Spannungsteilerwiderstände 21 bis 26 sowie zusätzliche Widerstände 27 bis 30 aufweist. Durch die Widerstandspaare 21, 24; 22, 25 und 23, 26 sind drei Spannungsteiler gebildet, deren Mittelpunkt jeweils an einen der Ausgänge 31, 32 bzw. 33 des Mikroprozessors 4 geschaltet ist und die einerseits an das gemeinsame Potential +U und andererseits an das Massepotential ausgeschlossen sind. Die Mittelpunkte der genannten Spannungsteiler sind jeweils über einen der Widerstände 28, 29 und 30 mit dem Eingang 18 des Oszillators verbunden. An dem gemeinsamen Verbindungspunkt der Widerstände 28, 29, 30 ist außerdem der Widerstand 27 zum Massepotential hin angeschlossen.

Am Ausgang 20 des Regelverstärkers 19 ist ein Tiefpaß aus einem ohmschen Widerstand 34 und einem Kondensator 35 vorgesehen. Deren Verbindungspunkt 36 ist an einem ersten Eingang 37 eines Komparators 38 angeschlossen, der ausgangsseitig mit dem Mikroprozessor 4 verbunden ist. Ein zweiter Eingang 39 des Komparators 38 ist über Widerstände 40, 41, 42 mit den Ausgängen 31, 32 bzw. 33 verbunden. Ein weiterer Widerstand 43 ist am Verbindungspunkt 39 zum Massepotential hin angeschlossen.

Weiterhin besteht eine Verbindung zwischen den Ausgängen 31 bzw. 32 des Mikroprozessors 4 einerseits und dem Ausgang 20 des Regelverstärkers 19 durch zwei weitere Widerstände 44 und 45, zu denen ein Widerstand 46 vom Verbindungspunkt zum Massepotential geschaltet ist.

Im folgenden wird die Funktion des vorangehend beschriebenen Näherungsschalters 1 mit Sendefrequenzabgleich näher erläutert.

Der Sendefrequenzabgleich des Näherungsschalters 1 wird über die Parametrierschnittstelle 14 aktiviert. Daraufhin werden die Ausgänge 31, 32, 33 des Mikroprozessors 4 in geeigneter Kombination nach High-Pegel (+U), Low-Pegel (Massepotential) oder Tristate (hochohmiger Zustand) geschaltet. Im Tristate-Betrieb liegt aufgrund der Spannungsteiler-Widerstände 21 bis 26 die Hälfte der gemeinsamen Versorgungsspannung +U an den Mittelpunkten der Spannungsteiler an, in den anderen beiden Zuständen entweder die volle Versorgungsspannung +U oder das Massepotential. Während der zyklische Sendetakt über den Ausgang 15 aktiv ist, wird die Oszillatorfrequenz des am Ausgang vom Oszillator 16 anstehenden Anregungssignals schrittweise über die Widerstände 27 bis 30 rampenförmig mit der maximal möglichen Auflösung von 27 Schritten angesteuert. Die Widerstände 28 bis 30 haben je nach Gewichtung entsprechend den Ausgängen 31, 32 und 33 eine wertemäßige Abstufung jeweils um den Faktor 3 und bilden zusammen mit dem Widerstand 27 einen Spannungsteiler zur Erzeugung der Steuerspannung mit unterschiedlicher Amplitude. Das Anregungssignal mit der entsprechenden Oszillatorfrequenz des Oszillators 16 wird während des über den Ausgang 15 vorgegebenen Sendetaktes freigegeben und gelangt über die Sendeendstufe 17 an den Ultraschall-Wandler 2.

Die Ultraschallwellen werden daraufhin vom Ultraschall-Wandler 2 mit der entsprechenden Sendefrequenz abgestrahlt und nach der Reflexion als Echo wieder empfangen. Im Verstärker 5 wird das vom Ultraschall-Wandler 2 erhaltene elektrische Signal auf einen verarbeitbaren Pegel gebracht, im nachgeschalteten Filter 6 von eventuellen Störsignalen befreit und nach Weiterverarbeitung im Demodulator 7 und Komparator 8 zur Auswertung im Mikroprozessor 4 eingespeist.

Um eine Übersteuerung des gefilterten elektrischen Signals und damit eine Reduzierung der Abgleichdynamik zu vermeiden, wird die Signalverstärkung über die Ansteuerung der Widerstände 44 bis 46 in Spannungsteilerschaltung durch die Ausgänge 31, 32 des Mikroprozessors 4 entsprechend angepaßt.

Die Information für den optimalen Abgleichwert für die Sendefrequenz wird durch Messung der den Echoamplituden proportionalen Regelspannung am Ausgang 20 des Regelverstärkers 19 bei der jeweils über den Oszillator 16 eingestellten Sendefrequenz erhalten. Hierzu wird mit Hilfe der Widerstände 40 bis 43 ein rampenförmiges Referenzsignal am Eingang 39 des Komparators 38 eingespeist und hier mit der Regelspannung verglichen. Diese wird durch den Tiefpaß, bestehend aus dem Widerstand 34 und dem Kondensator 35, gemittelt und steht damit für die Messung als zeitunkritisches Signal zur Verfügung. Ausgangsseitig wird am Komparator 38 ein digitalisiertes Signal ausgegeben, dessen Pulsweitenvarianz die gemessene Amplitude wiedergibt und im Mikroprozessor 4 weiterverarbeitet wird.

Bei externer Verarbeitung werden die Pegel der Regelspannung je nach Geräteausführung in Strom-, Spannungs- oder Frequenzwerte umgewandelt, in einem gesonderten Prüfaufbau zyklisch gemessen und dort den entsprechenden Sendefrequenzwerten zugeordnet. Es wird dann der optimale Abgleichwert bei Regelspannungsmaximum ermittelt und dieser Frequenzwert bzw. die entsprechenden Einstellwerte per Parametrierschnittstelle 14 dem Mikroprozessor 4 zur Abspeicherung übergeben.

Bei interner Verarbeitung ermittelt der Mikroprozessor 4 anhand eines hier nicht näher zu beschreibenden Ablaufprogramms die optimale Abgleichfrequenz für den Ultraschall-Wandler 2 und speichert die hierfür ermittelte Pegelkombination an den Ausgängen 31 bis 33 des Mikroprozessors 4 ab.

Nach Abschluß des Sendefrequenz-Abgleichvorgangs liegt dann im Normalbetrieb des Ultraschall-Näherungsschalters 1 die ermittelte Pegelkombination für die optimale Sendefrequenz des Ultraschall-Wandlers 2 während des Sendetaktes an den Ausgängen 31 bis 33 des Mikroprozessors 4 an.

Erhält der Mikroprozessor 4 Informationen über die Außentemperatur, so kann für den Normalbetrieb eine automatische Nachführung der Oszillatorfrequenz über die Ausgänge 31 bis 33 zur Anpassung an die Temperaturdrift der Resonanzfrequenz des Ultraschall-Wandlers 2 erfolgen. Hierzu ist allerdings Voraussetzung, daß im Mikroprozessor 4 der Einfluß der Temperatur auf die Frequenz des Ultraschall-Wandlers sowie die jeweils gültige Pegelkombination zur Nachführung der Oszillatorfrequenz abgespeichert sind.

Die Einstell- und Meßfunktionen am Mikroprozessor 4 werden durch die Ansteuerung des Widerstandsnetzwerks im Zeitmultiplexverfahren realisiert, was einen geringen Hardware-Aufwand ermöglicht. Durch eine Erweiterung des Widerstandsnetzwerks und der Mikroprozessorausgänge kann die Auflösung der Einstell- und Meßfunktionen nahezu beliebig gesteigert werden. Dabei ist von Vorteil, daß kein zusätzlicher Eingriff von außen erforderlich ist. In Verbindung mit der üblicherweise vorhandenen Parametrierschnittstelle 14 ist ein automatisierter Sendefrequenzabgleich des kompletten und eventuell bereits vergossenen Näherungsschalters 1 ohne zusätzliche Kontaktiermaßnahmen auch vor Ort in der Anwendung möglich.

Die geräteinterne Messung der Prüfsignale vermeidet die ansonsten bei externer Signalauskopplung üblichen Probleme durch Störeinflüsse infolge von Masseschleifen, Rauschsignalen, Schwingneigungen usw.

Ein weiterer Vorteil des oben beschriebenen Näherungsschalters ist es, daß die Ausgabe der Meßwerte und eventueller Fehler sowie die Einstellung der Abgleichparameter ohne zusätzlichen Hardware-Aufwand und mit wesentlich einfacheren Fertigungsvorrichtungen über die Parametrierschnittstelle des Näherungsschalters erfolgen kann.

## Patentansprüche

1. Verfahren zum Sendefrequenzabgleich eines Ultraschall-Näherungsschalters (1), der einen Ultraschall-Wandler (2), einen Oszillator (16), einen Verstärker (5) und einen Mikroprozessor (4) umfaßt, wobei der Oszillator (16) den Ultraschall-Wandler (2) mit einer Oszillatorfrequenz anregt, die von der Amplitude einer am Oszillator (16) angelegten Steuerspannung abhängt, und der Ultraschall-Wandler (2) daraufhin ein Ultraschallsignal mit entsprechender Sendefrequenz aussendet, das er nach Reflexion als Ultraschall-Echosignal empfängt und in ein elektrisches Signal umwandelt, das im Ultraschall-Näherungsschalter (1) weiterverarbeitet wird und proportional zur Amplitude des empfangenen Ultraschall-Echosignals ist, **dadurch gekennzeichnet, daß** die Steuerspannung über ein mit Ausgängen des Mikroprozessors verbunderes Wetzwerk durch den Mikroprozessor (4) verändert wird und das daraufhin geänderte, zur Amplitude des empfangenen Ultraschall-Echosignals proportionale weiterverarbeitete, elektrische Signal mit Hilfe des Mikroprozessors (4) amplitudenmäßig ausgewertet wird und das Auswerteergebnis sowie die zugehörigen Einstellwerte jeweils abgespeichert und daß die Einstell- und Meßfunktionen durch den Mikroprozessor (4) durch Ansteuerung des Wekwerks im Zeitmultiplexverfahren realisiert werden.

2. Verfahren nach Anspruch 1, **dadurch gekennzeichnet, daß** die Veränderung der Steuerspannung durch Zustandswechsel an Ausgängen (31, 32, 33) des Mikroprozessors (4) erfolgt.

3. Verfahren nach Anspruch 2, **dadurch gekennzeichnet, daß** das dem Oszillator (16) vorgeschaltete Netzwerk Widerstände (21 bis 30) zur Bewirkung eines Potentialwechsels aufweist.

4. Verfahren nach einem der vorangehenden Ansprüche, **dadurch gekennzeichnet, daß** die amplitudenmäßige Auswertung des elektrischen Signals durch Vergleich mit einer Referenzspannung erfolgt, die durch Zustandswechsel an Ausgängen (31, 32, 33) des Mikroprozessors (4) verändert wird.

5. Verfahren nach einem der vorangehenden Ansprüche, **dadurch gekennzeichnet, daß** der Mikroprozessor (4) selbständig die Einstellwerte für die optimale Sendefrequenz ermittelt , indem er aus den erfaßten Amplituden des elektrischen Signals die höchste auswählt, und abspeichert.

6. Verfahren nach einem der vorangehenden Ansprüche, **dadurch gekennzeichnet, daß** das elektrische Signal eine dem Verstärker (5) zugeführte Regelspannung ist.

7. Ultraschall-Näherungsschalter (1) mit einem Ultraschall-Wandler (2), mit einem Oszillator (16), durch den der Ultraschall-Wandler (2) zur Aussendung von Ultraschallwellen mit einer der Oszillatorfrequenz entsprechenden Sendefrequenz anregbar ist, wobei die Oszillatorfrequenz von der Amplitude einer am Eingang (18) des Oszillator (16) anliegenden Steuerspannung abhängt, und mit einem Mikroprozessor (4) zur Steuerung und Auswertung der Sende- und Empfangssignale des Ultraschall-Näherungsschalters (1), **dadurch gekennzeichnet, daß** der Eingang (18) des Oszillators (16) über ein Netzwerk (21, 22, 23, 24, 25, 26, 27, 28, 29, 30) mit Ausgängen (31, 32, 33) des Mikroprozessors (4) elektrisch verbunden ist, und daß durch Zustandswechsel an den Ausgängen (31, 32, 33) die Steuerspannung am Eingang (18) veränderbar ist und daß die Ausgänge (31, 32, 33) zur Realisierung von Einstell- und Meßfunktionen durch den Mikroprozessor (4) durch Ansteuerung des Netzwerks im Zeitmultiplexverfahren dienen.

8. Ultraschallnäherungsschalter nach Anspruch 7, **dadurch gekennzeichnet, daß** eine Meßeinrichtung (38, 40, 41, 42, 43) vorgesehen ist, die zur Messung der Amplitude eines im Ultraschall-Näherungsschalter (1) nach Empfang eines Ultraschall-Echosignals, weiterverarbeiteten elektrischen Signals dient, das proportional zur Amplitude des Ultraschall-Echosignals ist.

9. Ultraschall-Näherungsschalter nach Anspruch 8, **dadurch gekennzeichnet, daß** die Meßeinrichtung einen Komparator (38) aufweist, der zum Vergleich der Amplituden des elektrischen Signals und einer amplitudenmäßig durch den Mikroprozessor (4) veränderbaren Referenzspannung dient.

10. Ultraschall-Näherungsschalter nach einem der Ansprüche 7, 8, 9, **dadurch gekennzeichnet, daß** zwischen einem Eingang (39) des Komparators (38) und Ausgängen (31, 32, 33) des Mikroprozessors (4) das Netzwerk (40, 41, 42, 43) geschaltet ist, und daß durch Zustandswechsel an den Ausgängen (31, 32, 33) die Referenzspannung veränderbar ist.

## Claims

1. A method for adjusting the transmit frequency of an ultrasonic proximity switch (1) which comprises an ultrasonic transducer (2), an oscillator (16), an amplifier (5) and a microprocessor (4), wherein the oscillator (16) excites the ultrasonic transducer (2) with an oscillator frequency which depends on the amplitude of a control voltage applied to the oscillator (16), and the ultrasonic transducer (2) then emits an ultrasonic signal with the corresponding transmit frequency, which signal it receives after reflection as an ultrasonic echo signal and converts into an electrical signal which is further processed in the ultrasonic proximity switch (1) and is proportional to the amplitude of the received ultrasonic echo signal, **characterized in that** the control voltage via a network connected with output terminals of the microprocessor is changed by the microprocessor (4) and **in that** the amplitude of the electrical signal then changed, which is proportional to the amplitude of the received ultrasonic echo signal and is further processed, is evaluated with the aid of the microprocessor (4), and the result of the evaluation and the associated setting values stored in each case and **in that** the adjustment and measurement functions are implemented by the microprocessor (4) through control of the network in a time-division multiplex method.

2. A method according to Claim 1, **characterized in that** the control voltage is changed through state changes at output terminals (31, 32, 33) of the microprocessor (4).

3. A method according to Claim 2, **characterized in that** the network upstream of the oscillator (16) has resistors (21 to 30) for effecting a switch of potential.

4. A method according to any one of the preceding claims, **characterized in that** the amplitude of the electrical signal is evaluated by comparison with a reference voltage which is changed by state changes at output terminals (31, 32, 33) of the microprocessor (4).

5. A method according to any one of the preceding Claims, **characterized in that** the microprocessor (4) independently determines the setting values for the optimum transmit frequency by selecting the highest amplitude from the recorded amplitudes of the electrical signal and storing said highest amplitude.

6. A method according to any one of the preceding Claims, **characterized in that** the electrical signal is a control voltage supplied to the amplifier (5).

7. An ultrasonic proximity switch (1) with an ultrasonic transducer (2), with an oscillator (16) by means of which the ultrasonic transducer (2) can be stimulated to emit ultrasonic waves with a transmit frequency corresponding to the oscillator frequency, wherein the oscillator frequency depends on the amplitude of a control voltage applied to the input terminal (18) of the oscillator (16), and with a microprocessor (4) for controlling and evaluating the transmit and receive signals of the ultrasonic proximity switch (1), **characterized in that** the input terminal (18) of the oscillator (16) is electrically connected via a network (21, 22, 23, 24, 25, 26, 27, 28, 29, 30) to output terminals (31, 32, 33) of the microprocessor (4), and **in that** the output terminals (31, 32, 33) serve the implementation of adjustment and measurement functions by the microprocessor (4) through control of the network in the time-division multiplex method.

8. An ultrasonic proximity switch according to Claim 7, **characterized in that** a measuring device (38, 40, 41, 42, 43) is provided which serves to measure the amplitude of an electrical signal, further processed in the ultrasonic proximity switch after receipt of an ultrasonic echo signal, said electrical signal being proportional to the amplitude of the ultrasonic echo signal.

9. An ultrasonic proximity switch according to Claim 8, **characterized in that** the measuring device has a comparator (38) which serves to compare the amplitudes of the electrical signal and of a reference voltage, the amplitude of which can be changed by the microprocessor (4).

10. An ultrasonic proximity switch according to one of Claims 7, 8, 9, **characterized in that** the network (40, 41, 42, 43) is connected between an input terminal (39) of the comparator (38) and output terminals (31, 32, 33) of the microprocessor (4), and **in that** the reference voltage can be changed by means of state changes at the output terminals (31, 32, 33).

## Revendications

1. Procédé pour l'équilibrage de fréquence d'émission d'un détecteur de proximité à ultrasons (1) qui comprend un transformateur d'ultrasons (2), un oscillateur (16), un amplificateur (5) et un microprocesseur (4), dans lequel l'oscillateur (16) excite le transformateur d'ultrasons (2) avec une fréquence d'oscillateur qui dépend de l'amplitude d'une tension de commande appliquée à l'oscillateur (16) et le transformateur d'ultrasons (2) émet alors un signal ultrasonore qui a une fréquence d'émission correspondante et qu'il reçoit après réflexion sous forme de signal d'écho ultrasonore et transforme en un signal électrique qui est traité encore dans le détecteur de proximité à ultrasons (1) et qui est proportionnel à l'amplitude du signal d'écho ultrasonore reçu, **caractérisé par le fait que** la tension de commande est modifiée par le microprocesseur (4) par l'intermédiaire d'un réseau relié à des sorties du microprocesseur, que l'amplitude du signal électrique encore traité alors modifié et proportionnel à l'amplitude du signal d'écho ultrasonore reçu est évaluée à l'aide du microprocesseur (4), que le résultat de l'évaluation ainsi que les valeurs de réglage associées sont mémorisés à chaque fois et que les fonctions de réglage et de mesure sont réalisées par le microprocesseur (4) via une commande du réseau dans un procédé de multiplexage temporel.

2. Procédé selon la revendication 1, **caractérisé par le fait que** la modification de la tension de commande est effectuée par des changements d'état à des sorties (31, 32, 33) du microprocesseur (4).

3. Procédé selon la revendication 2, **caractérisé par le fait que** le réseau branché du côté amont de l'oscillateur (16) comporte des résistances (21 à 30) pour provoquer un changement de potentiel.

4. Procédé selon l'une des revendications précédentes, **caractérisé par le fait que** l'évaluation en amplitude du signal électrique est effectuée par une comparaison à une tension de référence qui est modifiée par des changements d'état à des sorties (31, 32, 33) du microprocesseur (4).

5. Procédé selon l'une des revendications précédentes, **caractérisé par le fait que** le microprocesseur (4) détermine de façon autonome les valeurs de réglage pour la fréquence d'émission optimale en sélectionnant et mémorisant la plus grande des amplitudes détectées du signal électrique.

6. Procédé selon l'une des revendications précédentes, **caractérisé par le fait que** le signal électrique est une tension de régulation envoyée à l'amplificateur (5).

7. Détecteur de proximité à ultrasons (1) comportant un transformateur d'ultrasons (2), un oscillateur (16) par lequel le transformateur d'ultrasons (2) peut être excité en vue de l'émission d'ondes ultrasonores ayant une fréquence d'émission correspondant à la fréquence d'oscillateur, la fréquence d'oscillateur dépendant de l'amplitude d'une tension de commande appliquée à l'entrée (18) de l'oscillateur (16), et un microprocesseur (4) destiné à la commande et à l'évaluation des signaux d'émission et de réception du détecteur de proximité à ultrasons (1), **caractérisé par le fait que** l'entrée (18) de l'oscillateur (16) est reliée électriquement par l'intermédiaire d'un réseau (21, 22, 23, 24, 25, 26, 27, 28, 29, 30) à des sorties (31, 32, 33) du microprocesseur (4), que la tension de commande à l'entrée (18) est modifiable par des changements d'état aux sorties (31, 32, 33) et que les sorties (31, 32, 33) servent à réaliser des fonctions de réglage et de mesure par le microprocesseur (4) via une commande du réseau dans un procédé de multiplexage temporel.

8. Détecteur de proximité à ultrasons selon la revendication 7, **caractérisé par le fait qu'**il est prévu un dispositif de mesure (38, 40, 41, 42, 43) qui sert à mesurer l'amplitude d'un signal électrique qui est traité dans le détecteur de proximité à ultrasons (1) après réception d'un signal d'écho ultrasonore et qui est proportionnel à l'amplitude du signal d'écho ultrasonore.

9. Détecteur de proximité à ultrasons selon la revendication 8, **caractérisé par le fait que** le dispositif de mesure comporte un comparateur (38) qui sert à comparer les amplitudes du signal électrique et d'une tension de référence modifiable en amplitude par le microprocesseur (4).

10. Détecteur de proximité à ultrasons selon l'une des revendications 7, 8, 9, **caractérisé par le fait que** le réseau (40, 41, 42, 43) est branché entre une entrée (39) du comparateur (38) et des sorties (31, 32, 33) du microprocesseur (4) et que la tension de référence est modifiable par des changements d'état aux sorties (31, 32, 33).
